Europäisches Patentamt

European Patent Office

Office européen des brevets

(19)

(11) Veröffentlichungsnummer: **0 266 488**
**A1**

## (12) EUROPÄISCHE PATENTANMELDUNG

(21) Anmeldenummer: 87109452.0

(22) Anmeldetag: 01.07.87

(51) Int. Cl.⁴: **G01R 21/00**

(30) Priorität: **13.10.86 CH 4075/86**

(43) Veröffentlichungstag der Anmeldung:
**11.05.88 Patentblatt 88/19**

(84) Benannte Vertragsstaaten:
**AT CH DE FR GB LI NL SE**

(71) Anmelder: **LGZ LANDIS & GYR ZUG AG**

**CH-6301 Zug(CH)**

(72) Erfinder: **Berner, Gerhard**
**Hofstrasse 35**
**CH-6300 Zug(CH)**

(54) **Neunziggrad-Phasenschieber.**

(57) Der Neunziggrad-Phasenschieber (3) für Blindleistungs-und Blindenergie-Messgeräte enthält mindestens ein Filter (9), welches ein Schalter-Kondensator-Filter ist, dessen Takteingang vom Eingangssignal (U) des Filters (9) über einen Schwellwertschalter (10) und einen Frequenzvervielfacher (11) angesteuert ist, die beide in der angegebenen Reihenfolge in Kaskade geschaltet sind. Der Wert der Frequenz (fc) des am Takteingang des Filters (9) anstehenden Taktsignals und der Wert des Gütefaktors (Q) des Filters (9) sind so gewählt, dass die durch das Filter (9) bedingte Phasenverschiebung neunzig Grad beträgt. Der Neunziggrad-Phasenschieber (3) benötigt keine höchst genauen, stabilen und somit teuren Komponenten.

## Fig. 2

EP 0 266 488 A1

## Neunziggrad-Phasenschieber

Die Erfindung bezieht sich auf einen Neunziggrad-Phasenschieber gemäss dem Oberbegriff des Anspruchs 1.

Derartige Phasenschieber werden mit Vorteil in Blindleistungs-Messgeräten oder in Elektrizitätszählern für Blindenergie verwendet zur Neunziggrad-Phasenschiebung eines der beiden Parameter Spannung u oder Strom i, bevor diese miteinander multiplizert werden zur Bildung des Strom/Spannungs-Produktes, welches bekanntlich proportional einer Leistung, d. h. im vorliegenden Fall proportional der Blindleistung ist.

Ein Neunziggrad-Phasenschieber der eingangs genannten Art ist aus der US-PS 4,055,803 bekannt, in der der Neunziggrad-Phasenschieber aus einem RC-Glied oder einem aktiven Filter besteht, welches ein RC-Glied enthält. Diese RC-Glieder benötigen bei der verlangten Genauigkeit des Phasenwinkels sehr genaue und sehr stabile Komponenten und damit sehr teure Kondensatoren.

Der Erfindung liegt die Aufgabe zugrunde, einen Neunziggrad-Phasenschieber zu realisieren, der annähernd temperaturunabhängige Frequenzeigenschaften besitzt und der keine höchst genauen, stabilen und somit teuren Komponenten benötigt.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen:

Fig. 1 ein Blockschaltbild eines Elektrizitätszählers zur Messung von Blindenergie,

Fig. 2 ein Blockschaltbild eines Neunziggrad-Phasenschiebers,

Fig. 3 ein Blockschaltbild eines Frequenzvervielfachers,

Fig. 4 ein Blockschaltbild eines Schalter-Kondensator-Allpassfilters,

Fig. 5 ein Blockschaltbild eines Neunziggrad-Phasenschiebers für Dreiphasen-Messgeräte und

Fig. 6 eine Summenschaltung.

Gleiche Bezugszahlen bezeichnen in allen Figuren der Zeichnung gleiche Teile.

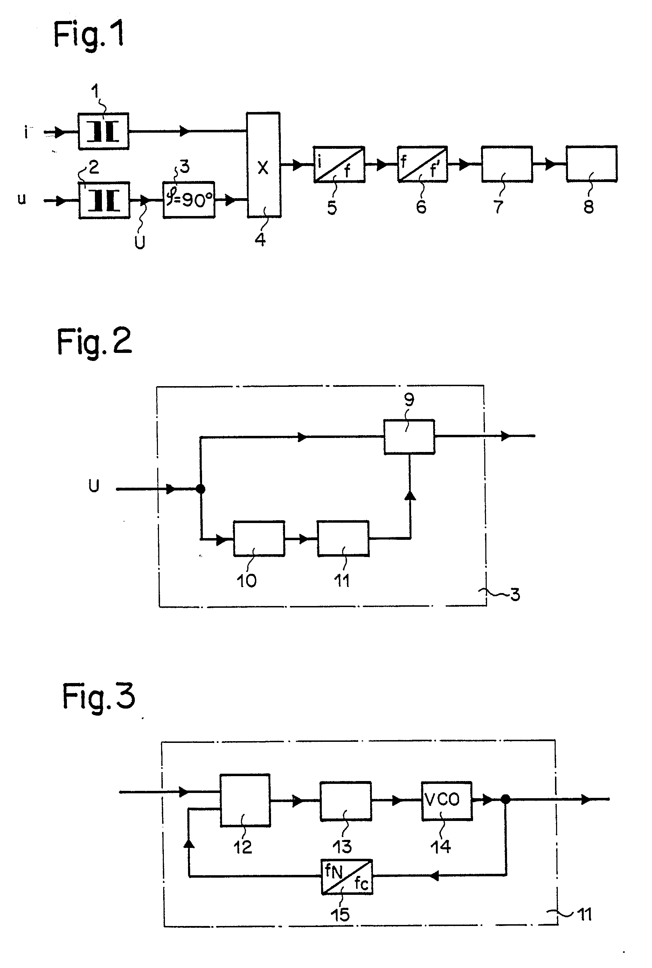

Der in der Fig. 1 dargestellte Elektrizitätszähler besteht aus einem Stromwandler 1, einem Spannungswandler 2, einem Neunziggrad-Phasenschieber 3, einem Multiplizierer 4, einem Strom/Frequenz-Wandler 5, einem Frequenzteiler 6, einem digitalen Zähler 7 und einer Anzeige 8. Ein Stromeingang des Elektrizitätszählers, an dem ein Stromsignal i ansteht, ist über den Stromwandler 1 mit einem ersten Eingang des Multiplizierers 4 verbunden. Ein Spannungseingang des Elektrizitätszählers, an dem ein Spannungssignal u ansteht, ist über den Spannungswandler 2 mit dem Eingang des Neunziggrad-Phasenschiebers 3 verbunden, dessen Ausgang auf einen zweiten Eingang des Multiplizierers 4 geführt ist. Der Strom/Frequenz-Wandler 5, der Frequenzteiler 6, der Zähler 7 und die Anzeige 8 sind in der angegebenen Reihenfolge in Kaskade geschaltet, wobei der Ausgang des Multiplizierers 4 mit dem Eingang der Kaskadenschaltung 5;6;7;8 verbunden ist. Der Neunziggrad-Phasenschieber 3 kann statt dem Spannungswandler 2 auch dem Stromwandler 1 nachgeschaltet sein, wenn der Strom zunächst in eine Spannung umgewandelt wird.

Der in der Fig. 2 dargestellte Neunziggrad-Phasenschieber 3 besteht aus einem Schwellwertschalter 10, z. B. einem Schmitt-Trigger, und einem Frequenzvervielfacher 11, die beide in der angegebenen Reihenfolge in Kaskade geschaltet sind, sowie aus einem Filter 9. Der Eingang des Neunziggrad-Phasenschiebers 3 wird gebildet durch die miteinander verbundenen Eingänge des Filters 9 und der Kaskadenschaltung 10;11, wobei der Ausgang der letzteren mit einem Takteingang des Filters 9 verbunden ist. Der Takteingang des Filters 9 wird somit von einem Eingangssignal U des Filters 9 über die Kaskadenschaltung 10;11 angesteuert. Der Ausgang des Filters 9 bildet den Ausgang des Neunziggrad-Phasenschiebers 3.

Der in der Fig. 3 dargestellte Frequenzvervielfacher 11 besteht aus einem Phasendetektor 12, einem Tiefpassfilter 13 und einem spannungsgesteuerten Oszillator 14, die alle drei in der angegebenen Reihenfolge in Kaskade geschaltet sind, sowie aus einem Frequenzteiler 15. Der Ausgang der Kaskadenschaltung 12;13;14 bildet einerseits den Ausgang des Frequenzvervielfachers 11 und ist anderseits mit dem Eingang des Frequenzteilers 15 verbunden, dessen Ausgang seinerseits auf einen ersten Eingang des Phasendetektors 12 geführt ist. Ein zweiter Eingang des Phasendetektors 12 bildet den Eingang des Frequenzvervielfachers 11.

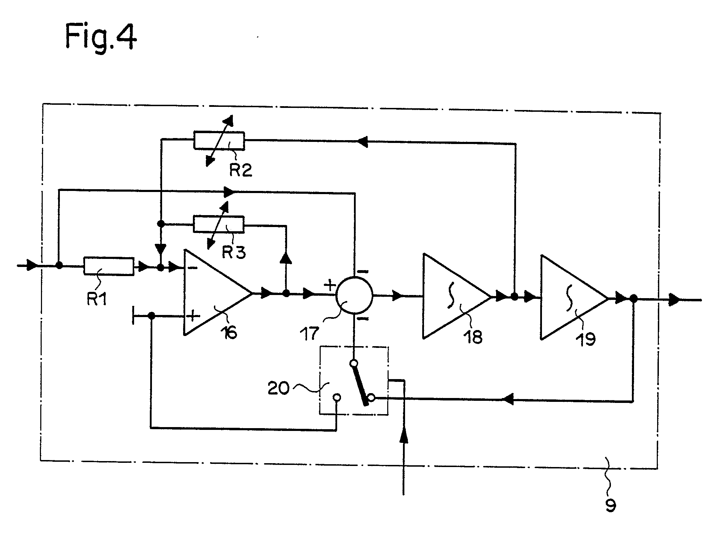

Das in der Fig. 4 dargestellte Filter 9 ist ein Schalter-Kondensator-Allpassfilter und besteht aus einem Operationsverstärker 16, einem Addierglied 17, einem ersten Integrator 18, einem zweiten Integrator 19, einem Umschalter 20 und drei Widerständen Rl, R2 und R3. Das Addierglied 17, der erste Integrator 18 und der zweite Integrator 19 sind in der angegebenen Reihenfolge in Kaskade geschaltet. Der Ausgang des Operationsverstärkers 16 ist direkt mit einem Plus-Eingang des Addiergliedes 17 und über den Widerstand R3 mit dem invertierenden Eingang des Operationsverstärkers 16 verbunden. Dieser invertierende Eingang ist ausserdem über den Widerstand R1 auf den Eingang des Filters 9 und über den Widerstand R2 auf den Ausgang des ersten Integrators 18 geführt. Der Eingang des Filters 9 ist zusätzlich mit einem ersten Minus-Eingang des Addiergliedes 17 verbunden. Der nichtinvertierende Eingang des Operationsverstärkers 16 liegt an Masse und ist über den Arbeitskontakt des Umschalters 20 auf einen zweiten Minus-Eingang des Addiergliedes 17 geführt. Der Ausgang des zweiten Integrators 19 bildet den Ausgang des Filters 9 und ist seinerseits über den Ruhekontakt des Umschalters 20 mit dem zweiten Minus-Eingang des Addiergliedes 17 verbunden. Der Steuereingang des Umschalters 20 bildet den Takteingang des Filters 9.

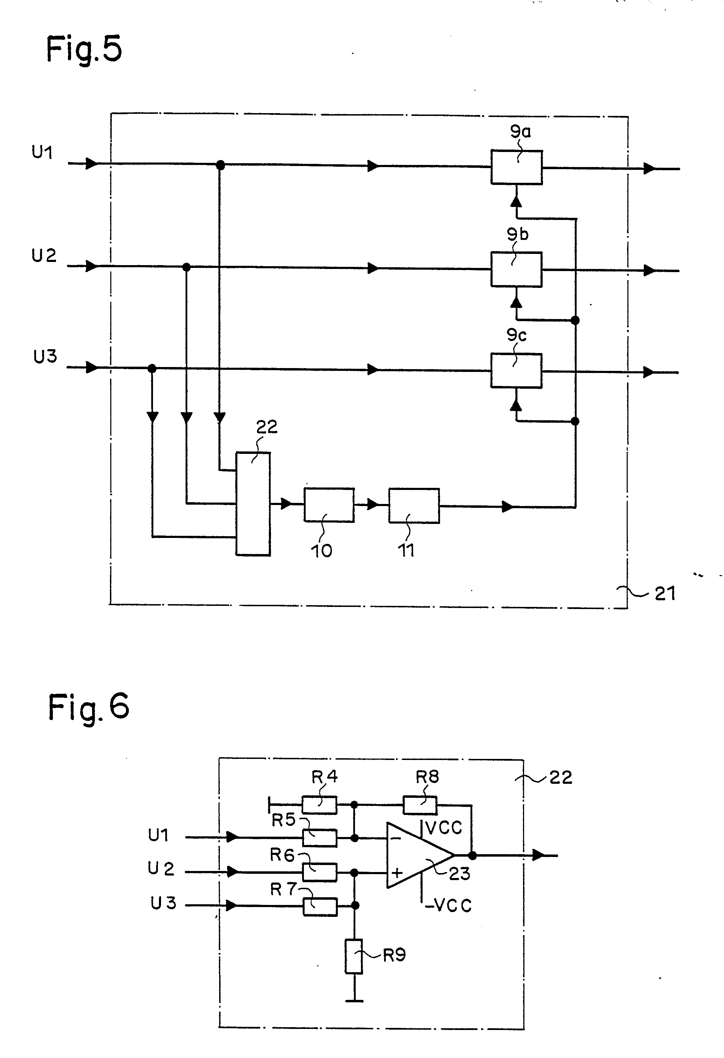

Der in der Fig. 5 dargestellte Neunziggrad-Phasenschieber 21 für ein Dreiphasen-Messgerät besteht aus einer Summenschaltung 22, dem Schwellwertschalter 10, dem Frequenzvervielfacher 11 und drei Filtern 9a, 9b und 9c, die alle drei gleich aufgebaut und vorzugsweise Schalter-Kondensator-Allpassfilter sind. Ein dreipoliger Eingang des Neunziggrad-Phasenschiebers 21 ist mit je einem Pol einerseits auf einen Pol des dreipoligen Eingangs der Summenschaltung 22 und anderseits auf den Eingang eines der drei Filter 9a, 9b oder 9c geführt. Der Schwellwertschalter 10 und der Frequenzvervielfacher 11 sind wieder in der angegebenen Reihenfolge in Kaskade geschaltet, und der Ausgang der Kaskadenschaltung 10;11 ist mit den drei Takteingängen der Filter 9a, 9b und 9c verbunden, während der Ausgang der Summenschaltung 22 auf den Eingang der Kaskadenschaltung 10;11 geführt ist. Die einpoligen Ausgänge der drei Filter 9a, 9b und 9c bilden den dreiphasigen Ausgang des Neunziggrad-Phasenschiebers 21.

Die in der Fig. 6 dargestellte Summenschaltung 22 besteht aus einem Operationsverstärker 23 und sechs vorzugsweise gleichen Widerständen R4, R5, R6, R7, R8 und R9. Der Operationsverstärker 23 wird von einer positiven und von einer negativen Gleichspannung VCC und -VCC gespeist. Ein Pol des dreiphasigen Eingangs der Summenschaltung 22 ist über den Widerstand R5 und die Masse über den Widerstand R4 mit dem invertierenden Eingang des Operationsverstärkers 23 verbunden, während die beiden anderen Pole des dreiphasigen Eingangs der Summenschaltung 22 über je einen Widerstand R6 bzw. R7 auf den nichtinvertierenden Eingang des Operationsverstärkers 23 geführt sind. Der Ausgang des Operationsverstärkers 23, der gleichzeitig der Ausgang der Summenschaltung 22 ist, ist über den Widerstand R8 mit dem invertierenden Eingang des Operationsverstärkers 23 verbunden, dessen nichtinvertierender Eingang ausserdem noch über den Widerstand R9 an Masse liegt.

In der Darstellung der Fig. 1 speist der Strom i den Stromwandler 1, in dem er in ein proportionales Spannungssignal umgewandelt wird. Die Spannung u speist den Spannungswandler 2, dessen u-proportionale Ausgangsspannung U den Neunziggrad-Phasenschieber 3 steuert. Der Multiplizierer 4 bildet das Produkt der Ausgangssignale des Stromwandlers 1 und des Neunziggrad-Phasenschiebers 3, ein Produkt, welches proportional dem Strom/Spannungs-Produkt i.u(90°) und damit proportional der Blindleistung ist. Der Ausgangsstrom des Multiplizierers 4 als Träger der Produkt-Information wird im Strom/Frequenz-Wandler 5 in eine proportionale Frequenz rechteckförmiger Impulse umgewandelt, die nach Teilung ihrer Frequenz im Frequenzteiler 6 vom digitalen Zähler 7 gezählt werden. Der Zählwert wird anschliessend in der Anzeige 8 angezeigt und stellt je nach Zähldauer des Zählers 7 die gemessene Blindleistung oder Blindenergie dar.

In dem in der Fig. 2 dargestellten Neunziggrad-Phasenschieber 3 wird die sinusförmige Ausgangsspannung U des Spannungswandlers 2, die in Europa eine Frequenz von 50 Hz und in den USA eine Frequenz von 60 Hz besitzt, durch den Schwellwertschalter 10 in ein rechteckförmiges Signal der gleichen Frequenz umgewandelt. Diese Frequenz wird anschliessend im Frequenzvervielfacher 11 multipliziert, um schliesslich als rechteckförmiges hochfrequentes Taktsignal den Takteingang des Filters 9 zu erreichen.

Der in der Fig. 3 dargestellte Frequenzvervielfacher 11 ist ein bekannter Phasenregelkreis (Phase Locked Loop: PLL) 12;13; 14;15, dessen Sollwert die Phase des Eingangssignals des Frequenzvervielfachers 11 und dessen Istwert die Phase des Ausgangssignals des Frequenzteilers 15 ist. Sollwert und Istwert werden im Phasendetektor 12 miteinander verglichen und das Sollwert/Istwert-Differenzsignal anschliessend im Tiefpassfilter 13 gefiltert, um schliesslich als Steuersignal den Steuereingang des spannungsgesteuerten Oszillators 14 (Voltage Controlled Oszillator) zu erreichen. Die Ausgangsfrequenz fc des spannungsgesteuerten Oszillators 14 wird mittels des Frequenzteilers 15 durch eine ganzwertige Zahl N geteilt. Die Frequenz des Istwertes ist somit fc/N und gleich der 50Hz-bzw. 60Hz-Frequenz des Sollwertes zu wählen. Der Phasenregelkreis 12;13;14;15 verstellt solange den Wert der Ausgangsfrequenz fc des spannungsgesteuerten Oszillators 14, bis die Sollwert/Istwert-Differenz annähernd gleich Null ist. Die Ausgangsfrequenz fc ist gleich N.50Hz bzw. gleich N.60Hz und das zugehörige Ausgangssignal des spannungsgesteuerten Oszillators 14 ist phasensynchron zum Eingangssignal des Frequenzvervielfachers 11. Der Frequenzteiler 15 ist z. B. ein bekannter, siebenstelliger Binärzähler. Der maximale Wert von N ist dann 128.

Das Filter 9 ist ein Schalter-Kondensator-Filter und vorzugsweise ein Allpassfilter. Nachfolgend wird angenommen, dass das Filter 9 obendrein ein Filter zweiter Ordnung ist und den in der Fig. 4 dargestellten Aufbau besitzt. Derartige Filter sind bekannt, im Handel z. B. bei der Firma National Semiconductor Corporation, 2900 Semiconductor Drive Santa Clara, Kalifornien, USA erhältlich und ihr Aufbau sowie ihre Funktionsweise in deren Datenblättern "MF10 Universal Monolithic Dual Switched Capacitor Filter" ausführlich beschrieben.

Ein Allpassfilter zweiter Ordnung hat einen Frequenzgang:

$$T(s) = [s^2 - (\Omega o/Q)s + \Omega_o^2]/[s^2 + (\Omega o/Q)s + \Omega_o^2]$$

mit $s = j\Omega$, wobei $\Omega = 2\pi f$ die Kreisfrequenz darstellt.

Der Amplitudengang dieses Allpassfilters ist:
$$|T(\Omega)| = 1$$
Der Phasengang dieses Allpassfilters ist dann:
$$\phi(\Omega) = -2 \cdot \text{arctg}\{\Omega.\Omega o/[Q.(\Omega_o^2 - \Omega^2)]\}$$
und demnach gelten:
$$\phi_{(\Omega = \Omega o)} = -180°$$ und
$$\phi_{(\Omega = \Omega m)} = -90°$$
mit $\Omega m = \Omega o.[-A + (A^2 + 1)^{1/2}]$     (I)

und $A = 1/(2Q)$

Das Allpassfilter besitzt somit bei der Frequenz $fm = \Omega m/2\pi$ eine Phasenverschiebung von -90° und sein Amplitudengang $|T(\Omega)|$ ist gleich 1.

Bei Elektrizitätszählern und Leistungsmessern ist die Frequenz fm gleich 50Hz (Europa) oder 60Hz (USA). Nachfolgend gilt die Annahme fm = 50Hz.

Bei handelsüblichen Schalter-Kondensator-Filtern ist die Resonanzfrequenz $fo = \Omega o/2\pi$ in der Regel gleich fc/100 oder fc/50, wobei fc die Taktfrequenz des Schalter-Kondensator-Filters darstellt. Nachfolgend wird angenommen, dass fo = fc/100.

Unter der Annahme, dass N = 128, gilt ausserdem die Gleichung fc = 128.fm, da der Frequenzvervielfacher 11 die Frequenz fm = 50Hz mit N multipliziert.

Es gilt somit schliesslich die Gleichung:

fo = fc/100 = N.fm/100 = 1,28.fm = 1,28.50Hz = 64Hz.

Durch Einsetzen dieses Wertes in die Gleichung (I) ergibt sich ein benötigter Wert des Gütefaktors von Q = 2,005, der bei handelsüblichen Filtern mit Hilfe einstellbarer Widerstände R2 und R3 (siehe Fig. 4) wählbar ist, da Q = R2/R3.

Anders ausgedrückt: Der Wert der Frequenz fc des am Takteingang des Filters 9 anstehenden Taktsignals bzw. der Wert von N ist dermassen zu wählen, dass gemäss Gleichung (I) bei Q annähernd gleich 2, die Frequenz fm des Filters 9, bei der dessen Phasenverschiebung -90° beträgt, gleich 50Hz ist, wobei der Feinwert des Gütefaktors Q mit Hilfe der Widerstände R2 und R3 eingestellt werden kann. Die Werte der Taktfrequenz fc und des Gütefaktors Q des Filters 9 sind somit immer so zu wählen, dass die durch das Filter 9 verursachte Phasenverschiebung neunzig Grad beträgt.

Der beschriebene Neunziggrad-Phasenschieber 3 hat den Vorteil, dass in seinem Schalter-Kondensator-Filter jeder Widerstand R herkömmlicher Filter durch je einen Schalter und einen Kondensator C ersetzt wird, wobei die Gleichung R = 1/(fc.C) gilt, in der fc die Taktfrequenz des Filters und damit auch die Umschaltfrequenz der Schalter darstellt. Dies hat zur Folge, dass jede Zeitkonstante RC' herkömlicher Filter durch die Zeitkonstante RC' = fc.(C'/C) ersetzt wird, die ausser von der Taktfrequenz fc des Filters 9 nur mehr vom Kapazitätsverhältnis C'/C der Kondensatoren abhängig ist. Die Schalter und Kondensatoren des Filters 9 sind vorzugsweise MOS-Transistoren bzw. MOS-Kondensatoren, da Schalter und Kondensatoren Bauelemente sind, die sich hervorragend zur Herstellung in MOS-Technologie eignen. Die Kapazitätsverhältnisse von MOS-Kondensatoren können ausserdem sehr stabil, sehr genau und preisgünstig hergestellt werden, so dass das mit MOS-Kondensatoren ausgerüstete Schalter-Kondensator-Filter und somit auch der Neunziggrad-Phasenschieber 3 keine teuren, sehr stabilen und sehr genauen Kondensatoren als Komponenten benötigt. Ausserdem weisen MOS-Kondensatoren ein hervorragendes Gleichlaufverhalten auf, so dass der Neunziggrad-Phasenschieber 3 nicht nur keine höchst genauen, stabilen und somit teuren Kondensatoren als Komponenten benötigt, sondern auch annähernd temperaturunabhängige Frequenzeigenschaften besitzt. Allpassfilter haben dabei obendrein den Vorteil, dass die Kreisfrequenz $\Omega m$, bei der die Phasenverschiebung des Schalter-Kondensator-Allpassfilters -90° beträgt, von zwei Parametern abhängig ist, nämlich von der Taktfrequenz fc und vom Wert des Gütefaktors Q des Filters, so dass die Abstimmung des Filters 9 wegen der vorhandenen zwei Freiheitsgrade relativ einfach ist. Filter höherer Ordnung als diejenigen der zweiten Ordnung benötigen mehr Komponenten und kommen daher in der Regel aus preislichen Gründen nicht in Frage.

Der in der Fig. 5 dargestellte Neunziggrad-Phasenschieber 21 für Dreiphasen-Messgeräte wird an seinem Eingang von der dreiphasigen Spannung U1;U2;U3 gespeist, wobei die einphasigen Spannungskomponenten U1, U2 und U3 je von einem nicht dargestellten Spannungswandler geliefert werden, ähnlich wie die Spannung U in der Fig. 1 vom Spannungswandler 2 erzeugt wird. Die vom dreiphasigen Eingangssignal U1;U2;U3 des Neunziggrad-Phasenschiebers 21 gespeiste, für alle Filter 9a, 9b und 9c gemeinsame Summenschaltung 22 bildet die algebraische Summe U2 + U3-U1 der Spannungen U1, U2 und U3, wobei der Operationsverstärker 23 in bekannter Weise als Summenverstärker arbeitet. Das Ausgangssignal der Summenschaltung 22 wird mittels des nachgeschalteten, ebenfalls gemeinsamen Schwellwertschalters 10 in rechteckförmige Impulse umgewandelt, deren Frequenz wieder mittels des Frequenzvervielfachers 11 mit der ganzwertigen Zahl N multipliziert wird. Zu jeder Phase gehört ein Schalter-Kondensator-Filter 9a, 9b oder 9c, dessen Eingänge jeweils von einer Phase des dreiphasigen Eingangssignal U1; U2;U3 des Neunziggrad-Phasenschiebers 21 und dessen parallelgeschaltete Takteingänge alle drei vom Ausgangssignal des gemeinsamen Frequenzvervielfachers 11 mit dem gleichen Taktsignal angesteuert werden. Die Ausgangssignale der drei Schalter-Kondensator-Filter 9a, 9b und 9c sind alle um -90° gegenüber dem Eingangssignal des zugehörigen Schalter-Kondensator-Filters 9a, 9b oder 9c verschoben und bilden somit zusammen eine um -90° gegenüber dem dreiphasigen Eingangssignal U1;U2;U3 phasenverschobene dreiphasige Ausgangsspannung.

## Ansprüche

1. Neunziggrad-Phasenschieber (3), insbesondere für Blindleistungs-und Blindenergie-Messgeräte, mit mindestens einem Filter (9), dadurch gekennzeichnet, dass das Filter (9) ein Schalter-Kondensator-Filter ist, dessen Takteingang vom Eingangssignal (U) des Filters (9) über einen Schwellwertschalter (10) und einen Frequenzvervielfacher (11) angesteuert ist, die beide in der angegebenen Reihenfolge in Kaskade geschaltet sind, wobei der Wert der Frequenz (fc) des am Takteingang des Filters (9) anstehenden Taktsignals und der Wert des Gütefaktors (Q) des Filters (9) so gewählt sind, dass die durch das Filter (9) bedingte Phasenverschiebung neunzig Grad beträgt.

2. Neunziggrad-Phasenschieber (3) nach Anspruch 1, dadurch gekennzeichnet, dass das Filter (9) ein Allpassfilter ist.

3. Neunziggrad-Phasenschieber (3) nach Anspruch 1 oder 2, dadurch gekennzeichnet, dass das Filter (9) ein Filter zweiter Ordnung ist.

4. Neunziggrad-Phasenschieber (3) nach einem der Ansprüche 1 bis 3, dadurch gekennzeichnet, dass die Schalter und Kondensatoren des Filters (9) in MOS-Technologie hergestellt sind.

5. Neunziggrad-Phasenschieber (21) für Dreiphasen-Messgeräte nach einem der Ansprüche 1 bis 4, dadurch gekennzeichnet, dass drei Filter (9a, 9b, 9c) vorhanden sind, deren Eingänge jeweils von einer Phase eines dreiphasigen Eingangssignals (U1;U2;U3) des Neunziggrad-Phasenschiebers (21) und deren Takteingänge alle drei vom Ausgangssignal eines gemeinsamen Frequenzvervielfachers (11) angesteuert sind, und dass einem gemeinsamen Schwellwertschalter (10) eine gemeinsame Summenschaltung (22) vorgeschaltet ist, deren dreipoliger Eingang vom dreiphasigen Eingangssignal (U1;U2;U3) des Neunziggrad-Phasenschiebers (21) angesteuert ist.

# Fig.1

# Fig.2

# Fig.3

## Fig.4

## Fig.5

## Fig.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | PROCEEDINGS OF IECON'85, San Francisco, 1985, Band 2, Seiten 722-728, IEEE, New York, US; G. ROY et al.: "A variable frequency power displacement factor measurement technique using a constant phase filter" * Seite 724, Spalte 1, Abschnitt 2 - Seite 727, Spalte 2, Abschnitt 2; Anhang; Figuren 4-13 * --- | 1 | G 01 R 21/00 |
| Y | EP-A-0 044 528 (CGEE ALSTHOM) * Seite 4, Zeile 14 - Seite 5, Zeile 5; Figuren 2,3 * --- | 1 | |
| Y | US-A-4 609 983 (BRAUN) * Zusammenfassung; Spalte 4, Zeile 20 - Spalte 5, Zeile 6; Figuren 5,6 * | 1 | |
| A | --- | 5 | |
| A | IEEE TRANSACTIONS ON INSTRUMENTATION AND MEASUREMENT, Band IM-30, Nr. 3, September 1981, Seiten 209-212, IEEE, New York, US; L.S. CZARNECKI: "Measurement principle of a reactive power meter for nonsinusoidal systems" * Seite 210, Spalte 2, letzter Abschnitt - Seite 212, Spalte 1, Zeile 1; Figuren 1-5 * --- | 1-3 | RECHERCHIERTE SACHGEBIETE (Int. Cl.4) G 01 R 21/00 |
| A | EP-A-0 052 256 (SIEMENS) * Seite 5, Zeile 3 - Seite 8, Zeile 28; Figuren 1-4 * --- | 1-3 | |
| A | DE-A-2 446 943 (BBC) * Seite 4, Zeilen 9-16; Figuren 3a,4 * --- -/- | 2 | |

Der vorliegende Recherchenbericht wurde für alle Patentansprüche erstellt

| Recherchenort | Abschlußdatum der Recherche | Prüfer |
|---|---|---|
| DEN HAAG | 29-01-1988 | TRELEVEN C. |

EPO FORM 1503 03.82 (P0403)

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PROCEEDINGS OF THE IEEE, Band 67, Nr. 1, Januar 1979, Seiten 61-75, IEEE, New York, US; R.W. BRODERSEN et al.: "MOS switched capacitor filters" * Seite 63, Spalte 2, Zeile 1 - Seite 64, Spalte 2, Zeile 8; Figuren 5,9 * ----- | 4 | |
| | | | RECHERCHIERTE SACHGEBIETE (Int. Cl.4) |

Der vorliegende Recherchenbericht wurde für alle Patentansprüche erstellt

| Recherchenort | Abschlußdatum der Recherche | Prüfer |
|---|---|---|
| DEN HAAG | 29-01-1988 | TRELEVEN C. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument

EPO FORM 1503 03.82 (P0403)